Europäisches Patentamt

European Patent Office

Office européen des brevets

⑩

(11) Publication number: **0 203 146**
**B1**

(12) **EUROPEAN PATENT SPECIFICATION**

(45) Date of publication of patent specification: **24.05.89**

(21) Application number: **85905997.4**

(22) Date of filing: **13.11.85**

(86) International application number:
**PCT/US85/02244**

(87) International publication number:
**WO 86/03341 05.06.86 Gazette 86/12**

(51) Int. Cl.⁴: **H 01 L 29/78,** H 01 L 21/28,
H 01 L 21/82

(54) **TRENCH TRANSISTOR.**

(30) Priority: **27.11.84 US 675305**

(43) Date of publication of application:
**03.12.86 Bulletin 86/49**

(45) Publication of the grant of the patent:
**24.05.89 Bulletin 89/21**

(84) Designated Contracting States:
**BE CH DE FR GB IT LI NL SE**

(56) References cited:
**EP-A-0 066 081**
**EP-A-0 094 891**
**US-A-4 296 429**
**US-A-4 419 811**

(73) Proprietor: **AMERICAN TELEPHONE AND TELEGRAPH COMPANY**
**550 Madison Avenue**
**New York, NY 10022 (US)**

(72) Inventor: **LANCASTER, Loren, Thomas**
**1717 Shenandoah Court**
**Allentown, PA 18104 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Courier Press, Leamington Spa, England.

## Description

### Background of the Invention

The continual shrinking of integrated circuit device packing density has recently produced a dramatic new direction for semiconductor device manufacture. That new direction is the building of device structures in three dimensions in the substrate crystal. The practical building block for these new devices is a trench structure formed into the silicon substrate. New anisotropic etching techniques make it possible to form deep trenches with steep, nearly vertical, sidewalls. Various workers have proposed the formation of trench isolation regions and trench capacitors for memory cells. A more recent, and less well known, proposal is to form trench gate structures. The latter proposal, embodied in U.S. Patent No. 4,455,740, issued June 26, 1984 to Hiroshi Iwai, was inspired by the desire to shrink MOS transistor dimensions, bringing the source and drain ever closer together. Iwai recognized that a point is reached where the source and drain are so closely spaced that punchthrough results. Accordingly, they teach a structure in which the source to drain spacing at the surface can be shrunk without regard to punchthrough by extending the gate length into the substrate, i.e. around the bottom of a trench, thereby physically separating the source and drain effectively in the vertical rather than the horizontal dimension.

It will be recognized that the foregoing proposal is essentially a technique for extending the length of the channel of an MOS device for a given surface area. Extending the length of the device decreases the operating speed of the device and decreases the gain of the device. These implications can be traded against the benefits just described and the trench gate structure, as envisioned by Iwai, may find significant device applications.

I have discovered a different trench gate device that resembles the Iwai device only in the respect that it employs a trench. In Iwai's device the trench is the gate of the device. In the device as claimed in claim 1 basically the entire device is built within the trench. That is, the source and drain regions also extend into the trench in order to realize all the benefits of my discovery. Primary among these is a substantial increase in the gain of the transistor for a given dimension. A host of new device structures are made possible using this approach.

The marriage of a trench capacitor with a trench gate is proposed in which an entire memory cell is formed essentially in the depth dimension of the substrate.

### Brief Description of the Drawings

Figure 1 is a schematic view, looking onto the top of a device constructed according to the invention;

Figures 2A and 2B are sectional views in perspective through the sections indicated in Figure 1;

Figure 3 is a schematic showing the dimensions used in describing the device;

Figure 4 is a perspective view of a multi-trench transistor according to a preferred embodiment of the invention;

Figures 5A to 5L are schematic representations of a sequence of processing steps useful for forming the structure shown in Figure 4;

Figure 6 is a perspective view of a modified trench transistor according to the invention;

Figures 7A to 7F are schematic representations of a sequence of processing steps useful for forming the structure shown in Figure 6;

Figures 8A to 8F are schematic representations of an alternative sequence of steps useful for forming trench transistor structures according to the invention.

### Detailed Description

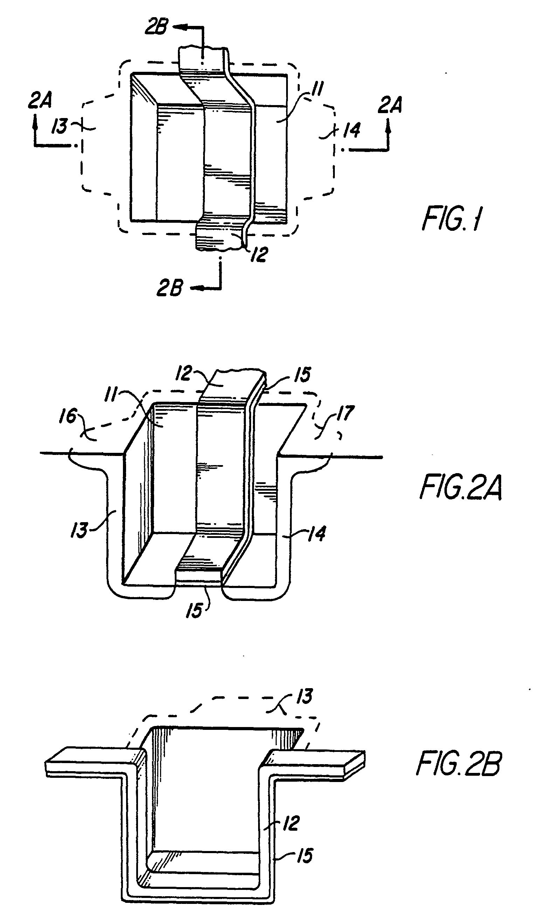

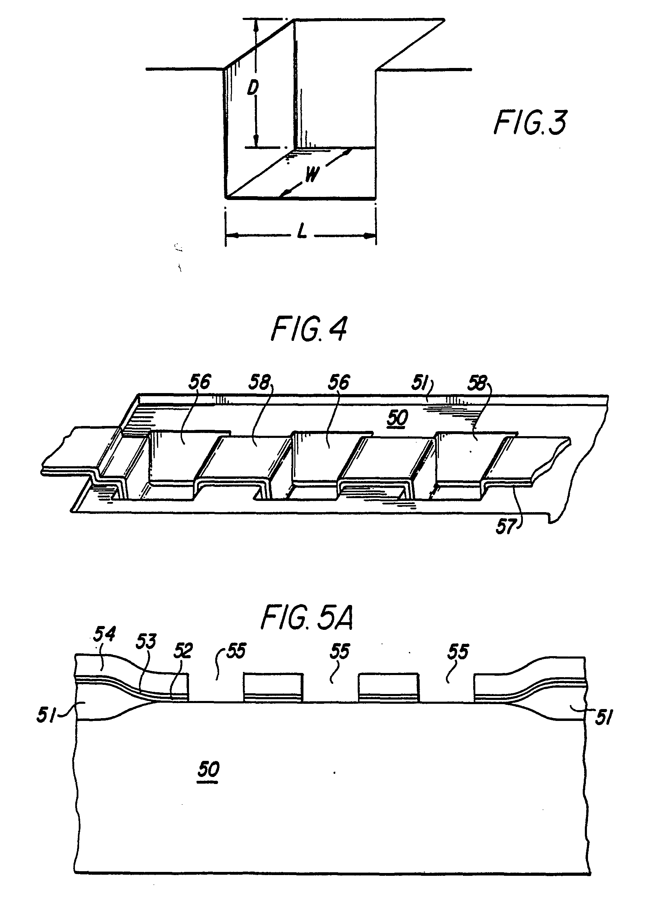

The basic trench transistor structure is schematically represented by the structure shown in Figure 1. Here a trench 11 is traversed by a gate 12. The gate separates source 13 from drain 14. The structure is shown in section in Figures 2A and 2B. The elements designated by common numerals are the same. Also shown in Figures 2A and 2B is gate dielectric 15. The portions 16 and 17 of the source and drain regions are provided to accommodate contact elements for source and drain contacts. The dimensions of the trench transistor are denoted W, L, and D as in Figure 3. The view of Figure 3 corresponds to that of Figure 2A.

The gain of an MOS transistor is proportional to the width of the channel of the transistor divided by its length. The width dimension is the distance measured along the edge of the gate that borders the source or drain. The length dimension is the distance separating the source and drain. Typically, for maximum device packing density the width is made approximately equal to the minimum linewidth of the technology being used. Again for optimum packing density the length is often chosen to be the same as the width. However, in a variety of devices, and in particular for logic devices and memory drivers, a higher transistor gain is desirable. This results in transistor designs with gate widths many times the gate length. Such structures are realized advantageously according to the invention in which the gate width is effectively multiplied. From Figure 2B it will be seen that the effective gate width is W + 2D. If D is equal to W, the gate width for this device is approximately three times the width of a conventional device occupying the same surface dimensions.

The gain advantage in the transistor device of this invention can be increased by providing a multiplicity of trench gates. Such a structure is shown in Figure 4. Here the width of the transistor is increased further using a series of trenches. This structure is recommended for high gain devices and may become the typical implementation of this invention. The advantage of the structure of Figure 4 will be evident from the following. Assume, for example, that W, L and D (Figure 3) are all equal to 3 μm, and the spacing between the trenches of Figure 4 is also equal to 3 μm. The active device surface area is 3 μm by 15 μm. A standard transistor occupying this surface area would provide a gate width of 15 μ. A single trench device as in Figure 1 having a 15 μ trench width would provide a gate width of 21 μ, a 40% increase. The gate width of the device of Figure 4, having three trenches, is 33 μ or a 220% increase in gate width. As the aspect ratio of trench depth to trench width increases, the power of the inventive concept is even more evident. If the trench is 6 μ deep, the gate width for a single trench device in the example is 27 μ, or nearly double the normal width (15 μ). The gate width for a multiple trench device as in Figure 4 is 51 μ, more than three times the width of a conventional device.

A variety of approaches for making these devices will occur to those skilled in the art. The required technology is currently known. Three general approaches for making the devices will be described.

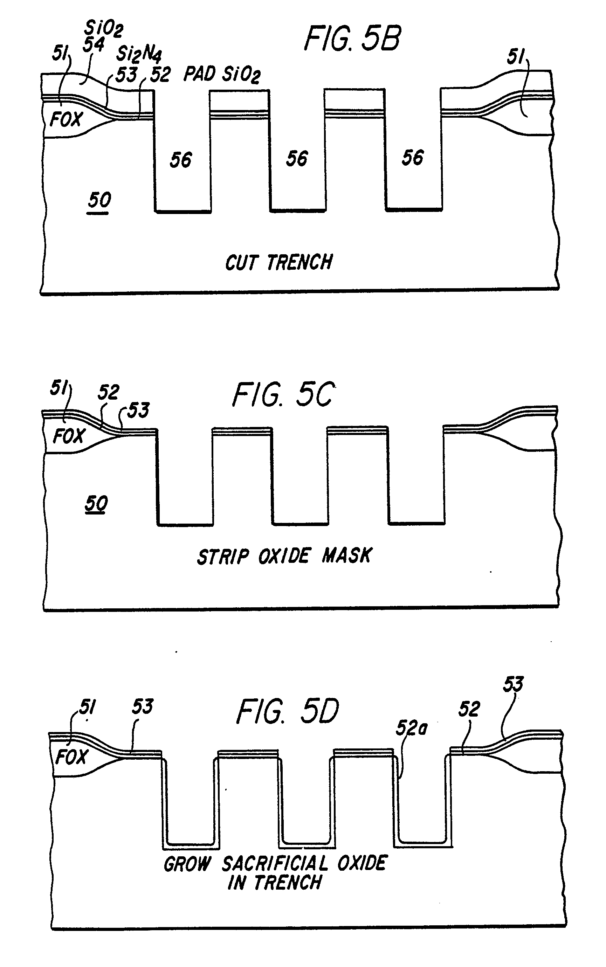

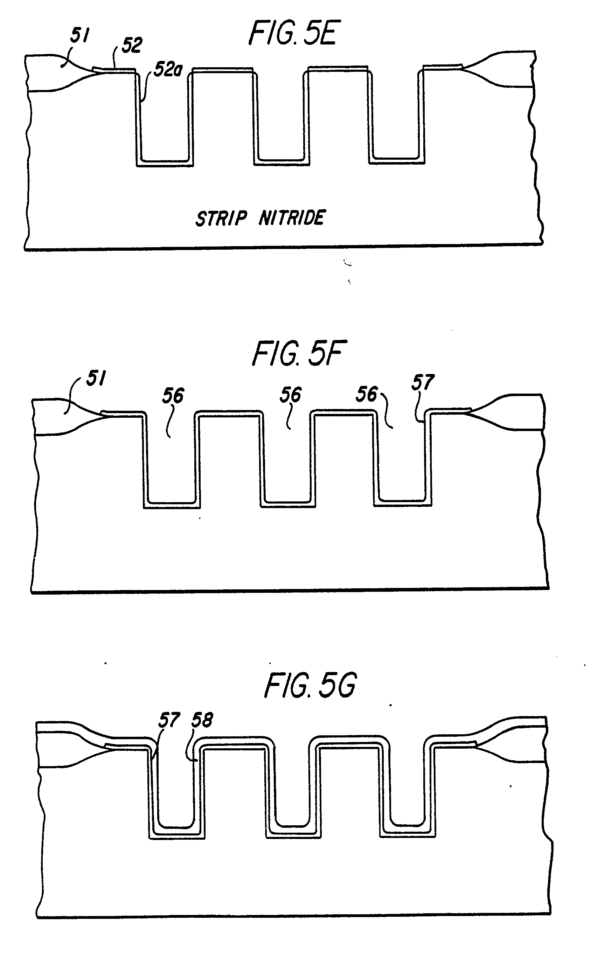

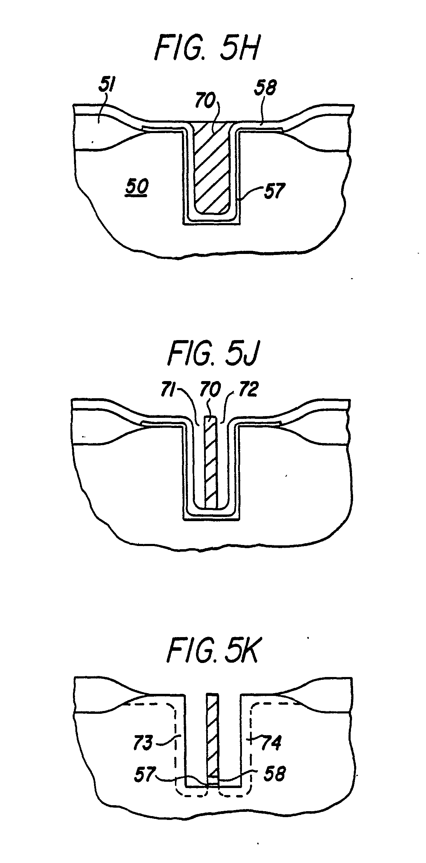

The first approach will be described in conjunction with Figures 4 and 5A to 5G. Figures 5A—5G are sectional views taken along the width W with the device and correspond in that respect with the section shown in Figure 2B. Figure 5A shows a semiconductor substrate 50, typically silicon, with a field oxide 51 produced in a conventional way, providing isolation around the device as shown. Formed over the substrate and field oxide is a mask layer comprising a pad oxide 52, a silicon nitride etch stop layer 53, and an oxide mask layer 54. The mask is patterned by conventional techniques, preferably by an anisotropic RIE technique, to form openings 55. An anisotropic RIE technique is used to form trenches 56 as shown in Figure 5B. The length L of the trench see Figures 2A and 3) includes the length of the gate. If we assume the gate length is the minimum dimension allowed in the technology being used, the length of the trench will be that dimension plus allowance for the source and drain regions. A suggested length in this example is 2 μ to 3 μ, 1 μ for the gate and the remainder for the source/drain. This assumes a minimum design rule of 1 μ. The width W and the spacing between openings are also of the order of 1 μ. The depth of the trench may be selected as desired and with the dimensions described here would typically be 1 μ to 4 μ. Due to the severity of the trench etch step, i.e. the damage caused to the silicon crystal, it is advantageous but not essential to "clean" the etched surfaces with standard silicon liquid etchants or by oxidizing a thin surface layer and stripping. The mask layers 52, 53, 54 may be removed at this point if desired. The oxide layer can be removed with buffered HF (Figure 5C). The nitride layer may be removed using phosphoric acid. Since this etch may attack the silicon it is helpful to form a sacrificial oxide 52a on the trench surfaces prior to nitride removal as shown in Figure 5D. The pad oxide 52 protects the silicon surface. After removing the nitride etch stop layer 53 as shown in Figure 5E, both the sacrificial oxide and the pad oxide can be removed with a light buffered HF etch step.

The reason for the silicon nitride etch stop is apparent here. It prevents removal of the field oxide when the trench mask layer is removed. Alternatively, the composite mask layer, or a part thereof may be left to a later stage in the process. With the substrate 50 stripped (except for FOX 51) and trenches 56 formed, the gate dielectric layer 57, typically silicon dioxide, is grown in the conventional way to produce the structure of Figure 5F. Other dielectrics, including dual or composite layers, notably silicon dioxide and silicon nitride, can be used as well. The dimensions already mentioned suggest a gate dielectric thickness of the order of 0.02 to 0.1 μ. Next, the gate electrode layer is formed by depositing polysilicon, or other appropriate conductor, e.g. polycide or refractory metal, over the whole structure and patterning to form gate electrode 58, as seen in Figures 4 and 5G. The patterning step is preferably performed using a bi-level or tri-level photoresist process. Such processes are now well known and have the ability to form accurate patterns in layers with severe topological variations, i.e. the so-called filler layer of the resist will fill the trenches in the topology leaving a relatively planar surface on which to project the photolithographic image. The pattern is then transferred effectively through the thick filler layer. An alternative is to fill the trench with a filler layer of, e.g. silicon dioxide, deposited e.g. using the well known TEOS process, or by low pressure CVD. The resulting structure is relatively planar, or can be etched back to planarize even further, and the photoresist layer is then applied thereover. After patterning of the gate electrode 58, the source/drain regions are formed. These may be formed by vapor phase diffusion or other appropriate techniques. If the transistor being fabricated is an n-channel device, arsine $AS_2O_3$ or their equivalent may be used to diffuse arsenic impurities into the regions abutting gate electrode 58. An oxide interlevel dielectric or passivating layer may then be formed as is standard in the art. Contact windows and contacts to source, drain and gate are formed in the usual manner.

The preferred approach among the variety of possibilities for making the trench transistor structure just described may be the use of a dielectric filler layer that is deposited in the trench and itself patterned by anisotropic etching techniques to form dual trenches to accommodate source and drain formation. This will be recognized as an adaptation of the multilevel lithography approach except that the filler layer is multifunctional. It serves as the etch mask for forming the gate electrode, a diffusion mask for forming the source and drain, and then remains in the structure as a filler to planarize the trench. The preferred materials for the filler layer are silicon dioxide and/or silicon nitride. Techniques for depositing and patterning these materials are well known, and their efficacy in this application is straightforward.

A suitable sequence of steps using this approach is shown in Figures 5H—5L. Figure 5H shows the planarized dielectric filler layer 70 filling the trenches. This sectional view, and the view of Figures 5J—L are taken along the length L of the device and correspond to the section shown in Figure 2A. This layer is anisotropically etched to produce source/drain trenches 71 and 72 as seen in Figure 5J ("I" is omitted). Next the exposed polysilicon is removed leaving gate 58 as in Figure 5K. Source/drain regions 73 and 74 are formed by diffusion or suitable means. Source/drain trenches are filled with dielectric 75 (see Figure 5L), which may, e.g. be CVD oxide using silane, TEOS or equivalent. Source/drain contacts 76 and 77 complete the assembly.

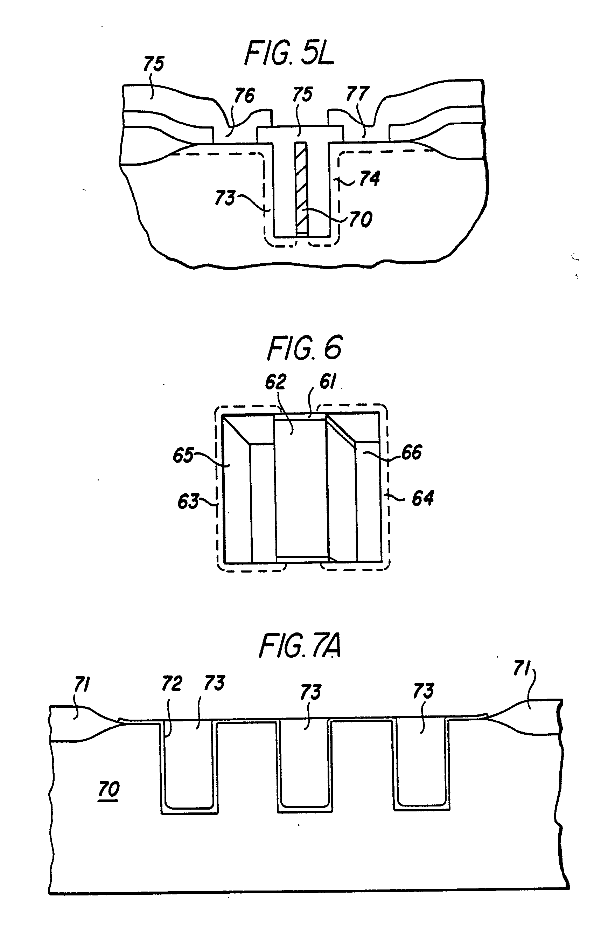

The second general approach to fabricating the structure of the invention is described in connection with Figure 6 and the process sequence of Figures 7A to 7F. These figures are sectional views similar to that of Figure 2B. The basic structure being made is shown schematically in Figure 6. The essential elements of the transistor, i.e. gate dielectric 61, gate electrode 62, source and drain 63 and 64 are shown. As will become evident this structure is characterized by a solid gate block filling a substantial portion of the trench, and secondary trenches 65 and 66 to accommodate formation of the source and drain regions in a manner similar to that just described in connection with Figures 5H to 5L. Figure 6 shows a single trench. Multiple trenches may be used in this embodiment also. The trench appears square in plan view. However, a structure optimized for maximum gate width will have a trench width chosen to be small, e.g. the minimum allowable dimension. The length of the trench will be larger, e.g. 3× the minimum, to allow for the source/drain formation. This comment applies as well to the devices described earlier. The objective is to maximize the impact of the D dimension. The W dimension is approximately the same whether the width is at the bottom of a trench or on the surface as in a conventional structure.

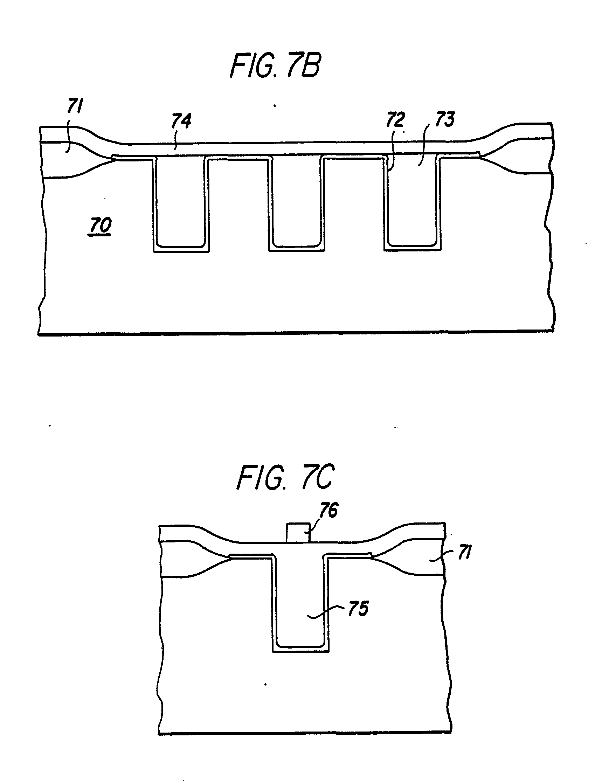

A suitable process sequence for making the device of Figure 6 will now be described in conjunction with Figures 7A to 7F. The first steps in the fabrication of the structure may be the same as those described in connection with Figures 5A and 5B and need not be repeated. The structure of Figure 5B is then processed by depositing a thick layer of polysilicon and then planarizing to effectively fill the trenches 56. The resulting structure is shown in Figure 7A with substrate denoted 70, field oxide 71, gate dielectric 72, and trenches filled with polysilicon 73. Techniques for filling the trenches with polysilicon and planarizing to produce a structure like that shown are known in the art and described for example in the Iwai patent mentioned earlier. The polysilicon is preferably deposited using a CVD process, a process that produces a conformal coating. The thickness of the polysilicon initially deposited is of the order of one half the width of the trench being filled, or more to ensure complete fill. The resulting polysilicon layer may then be etched back if necessary resulting in the planar structure of Figure 7A. A planar structure results because the surface layer clears at a point where the trench is still filled. It may be found convenient in some cases to leave the layer as deposited although the layer may be unusually thick for a surface layer. In the preferred sequence the layer is planarized to form the structure of Figure 7A, and an interconnect layer is then deposited. This layer, 74 in Figure 7B, is also preferably polysilicon, and interconnects the polysilicon bodies within the trenches. It also provides device interconnections, or surface regions for interlevel connections, as is standard in the art. This layer may be patterned to provide these features at this stage in the processing, but is preferably patterned at the stage represented by Figure 7C.

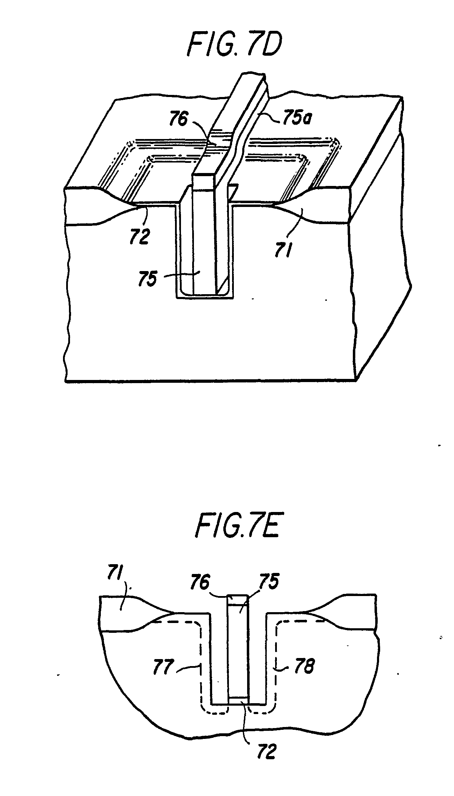

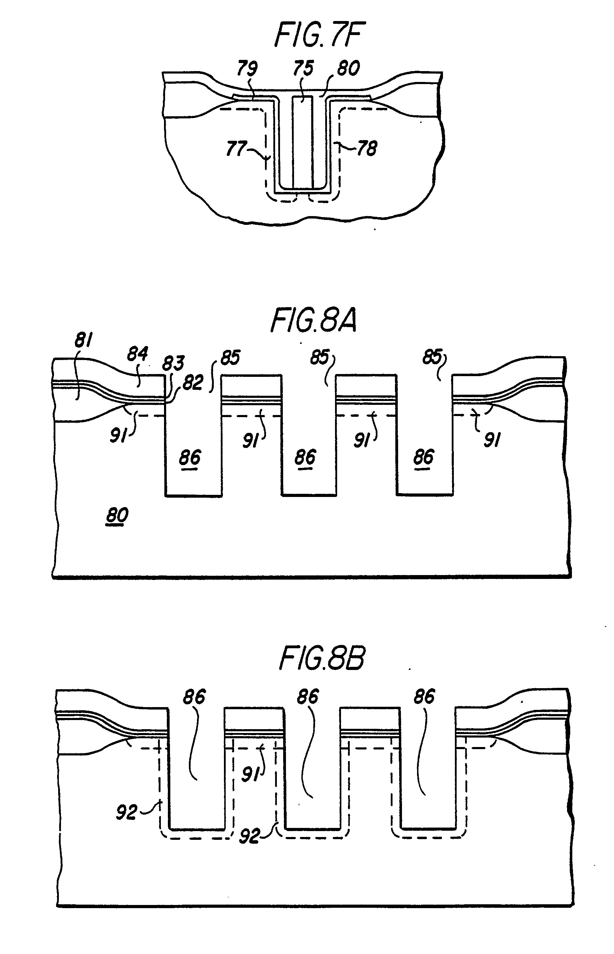

The next steps are more clearly illustrated using sectional schematics in the other dimensions, i.e., sections similar to that of Figure 2A, a cross section along the gate length rather than the width. Only one trench appears in this section. In Figure 7C the polysilicon layer 75, here shown as if layers 73 and 74 are merged as one, is masked with a trench etch mask 76. Since field oxide 71 is protected by polysilicon layer 75, a nitride etch stop layer like 53 is not necessary. Consequently mask 76 is preferably a layer of thick silicon dioxide, e.g. 0.1 to 1.00 μm. Mask 76 is formed as shown in Figure 7C. Layer 75 is etched anisotropically as shown in the perspective view of Figure 7D to form the gate electrode structure, and the gate interconnect 75a. The exposed portion of the gate dielectric layer 72 may then be removed (optional) and source and drain impurity regions 77 and 78 formed, e.g. by diffusion, using e.g. arsine vapor, as shown in Figure 7E. The mask 76 may be removed or retained as desired. A protective layer 79 is grown on the exposed silicon, Figure 7F, and a thick silicon dioxide or doped glass layer 80 is deposited thereover to fill the remainder of the trench. Contact windows and contact layers (not shown) are made in the conventional way.

Those skilled in the art will recognize that the etch step described in connection with Figure 7D requires effective selectivity between the material of the gate electrode, 75, and the layer 72. With the materials described, and state of the art processing, sufficient selectivity is available for forming a useful trench structure. However, if very deep trench structures are desired, more selective etch processes, or alternative sequences may be desirable. Several such proposals can be recommended. A sacrificial etch stop layer, e.g. molybdenum or other metal, can be deposited between layer 72 and layer 75 to ensure complete etching within the trench without excessively attacking the material between the trench or the unmasked border around the trench. That etch stop layer is subsequently removed except for the portion that is masked by the gate electrode. That portion becomes part of the gate. Another option is to choose a gate material that exhibits high selectivity with respect to layer 72. Although polysilicon is the preferred material for the gate electrode, other conductive materials may be found with higher selectivity to silicon dioxide or silicon nitride. Another alternative, one that is preferred for reasons that will be apparent, is to mask the surface portion of the substrate and the border portions around the trench, with a relatively durable etch mask. This approach can be implemented conveniently by leaving mask layers 52, 53, and 54 (see Figure 5A) in place after the trench is formed, growing the gate dielectric layer 72 within the trench, and depositing layer 73 as shown in Figure 7A. Layer 73 is etched to the bottom of the trench as shown in Figure 7D and the surface portions are protected by etch mask 54. The upper surface portions of the transistors may thereby be rendered ineffective. However, the advantages obtained by extending the transistors in the depth dimension will outweigh the loss of the upper surface portion of the transistor.

Other schemes can be devised by workers in the art for overcoming the difficulties just described and optimizing the processing sequence. The approaches described here should be regarded as examples only.

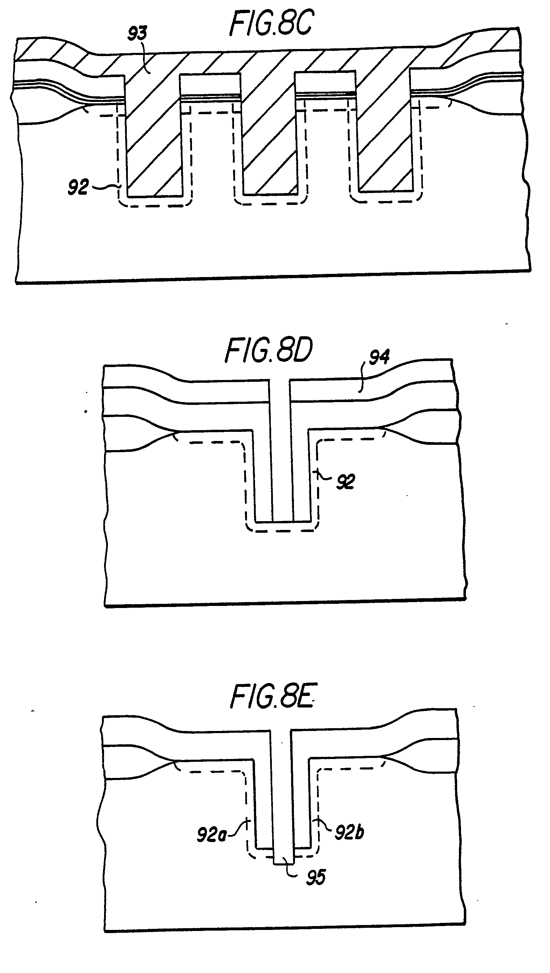

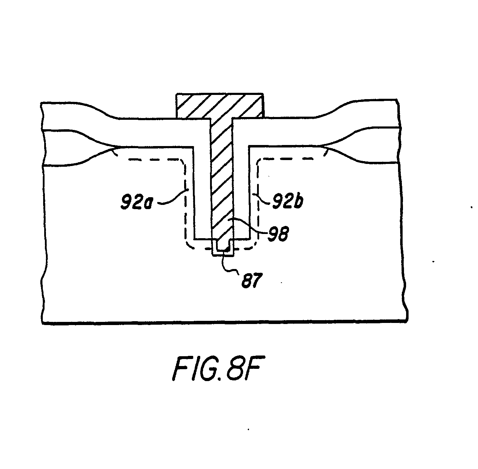

The third general approach to making the trench structures of the invention represents a departure from convention. That approach is to form the source/drain regions prior to formation of the gate. The gate is then produced by a self aligned technique that can be characterized as a trench gate within a trench transistor. This approach is illustrated in Figures 8A to 8F. Again the structure of Figure 5A is the starting point with the exception that preferably a selective implant is made into appropriate regions of the substrate surface after formation of the field oxide (and chan stops or other standard isolation means) and before masking for the trench etch (82—84 of Figure 8A). This implant, n-type for an n-channel device, will later facilitate connection to the largely buried source and drain regions as will become evident as the sequence proceeds. The surface implant is relatively heavy as is conventional for source/drain implants and is designated 91 in Figure 8A. In the other dimension it is masked, or otherwise processed, to provide separation between source and drain. Figure 8A otherwise is similar to Figure 5A with numerals 50—55 changed to 80—85. Figure 8A in addition shows the trenches 86 already etched according to a sequence described in connection with Figure 5. The source/drain regions are then formed. As shown at 92 in Figure 8B to connect with the surface implant 91 as shown. A thick layer of dielectric material, e.g. CVD silicon dioxide, TEOS silicon dioxide, p-glass or the like, designated 93 in Figure 8C, is then deposited to fill the trenches 86. This layer functions primarily as a filler and may comprise one of more of a variety of materials. Although the oxides mentioned are preferred, silicon nitride, or a silicon dioxide/silicon nitride composite would also be suitable. Layer 93 may be planarized to reduce the surface thickness or so that it just, or nearly, fills trenches 86. Layer 93 is then masked by mask 94 shown in Figure 8D, and etched to the bottom of the original trench as shown in Figure 8D. Figures 8D—8F are sections taken along the length dimensions as in Figure 2A. At this point the silicon substrate exposed in the former etch step is etched along the bottom of the trench and up the sidewalls of the trench to form a second trench 95 as shown in Figure 8E. This trench comprises the gate structure for the device. It bisects the implant layer 92 into separate regions 92a and 92b to form the source and drain regions. The gate is completed by growing gate dielectric 97 to a thickness of a few hundred to a thousand angstroms, then depositing the gate electrode 98 to form the structure of Figure 8F. The gate structure 98 is self-aligned to source/drain regions 92a and 92b. The gate electrode material is preferably polysilicon but may be any suitable conductor material. Since the thermal processing is essentially complete at this stage of the sequence the gate electrode may be aluminum, preferably deposited by a CVD technique to obtain complete coverage into the second trench.

In the trench gate structure proposed by Iwai the bottom of the trench interconnects the channel formed along the sides of the trench. Therefore the trench bottom is an essential part of the source drain conduction path and cannot be interrupted. In the structures proposed here the advantages are due largely to the portion of the transistor that conducts along the sidewalls. The bottom of the trench is expendable. But the practical realization of certain embodiments of the trench transistors described here may suffer because of leakage or other defects associated with the bottom of the trench. The bottom may be implanted with the substrate impurity type to shut off conduction and leakage at the trench bottom. Implanting selectively into the bottom of the trench is straightforward because of the directonal nature of the implant beam. The doping level need only be sufficient to reduce leakage. Alternatively a thick dielectric can be provided in the trench bottom to achieve a similar result.

## Claims

1. MOS transistor device comprising:
a semiconductor substrate,
a trench (11) formed into said semiconductor substrate said trench comprising a first pair of oppositely disposed sidewalls, a second pair of oppositely disposed sidewalls, and a bottom,
characterised by
an MOS transistor source region (13) extending along one of said first pair of sidewalls,
an MOS transistor drain region (14) extending along the other of said first pair of sidewalls,
a gate dielectric layer (15) covering at least partially said second pair of sidewalls,

and an MOS transistor gate electrode (12) extending along said second pair of sidewalls, one edge of said gate electrode overlying the edge of said source region and the other edge of said gate electrode overlying the edge of the drain region.

2. Device of claim 1 in which the semiconductor is silicon.

3. Device of claim 1 in which the gate electrode is polysilicon.

4. Device of claim 1 further including an additional transistor device as defined in claim 1 adjacent to the first with the gate electrode of the first transistor and the gate electrode of the additional transistor merged together.

5. Method for making an MOS transistor device as claimed in any of the preceding claims comprising the steps of:

forming a trench into one surface of a semiconductor substrate, said trench having a pair of opposing sidewalls, a pair of opposing endwalls and a bottom,

characterized in that

forming a gate structure (12, 15) in the trench (11) extending continuously down along one sidewall, along the trench bottom and upward along the other sidewall, said gate structure comprising a dielectric layer and an electrode layer overlying the dielectric layer,

forming a first impurity region into the surface regions of the trench not covered by the gate electrode, and

forming a source contact to the impurity region on one side of the gate electrode, and

forming a drain contact to the impurity region on the other side of the gate electrode.

6. The method of claim 5 in which the impurity region extends to and along the said surface of the substrate and the said source and drain contacts are formed on the said surface.

7. The method of claim 5 in which the gate structure is formed by forming a gate dielectric layer on at least the endwalls and bottom of the trench, filling the trench with polysilicon to a level approximating the level of the surface of the substrate, forming a mask for the gate structure on the surface of the said polysilicon, etching the unmasked polysilicon through to the bottom of the trench, leaving a portion of the original trench open on either side of the gate structure, introducing impurities into the open portions to form the sources and drain regions, and filling said open portions with dielectric material.

8. The method of claim 5 in which the gate structure is formed by introducing impurities into the walls of the trench to a first depth to form a layer of impurities along said endwalls, sidewalls and bottom, filling the trench with dielectric material to a level approximating the level of the surface of the substrate, masking the dielectric material with a resist layer that exposes a strip extending between the endwalls of the trench and spaced from each sidewall, etching the exposed dielectric material to form a second trench, smaller than the first, extending between the endwalls and spaced from the sidewalls, etching the exposed portions of the trench walls exposed by the aforementioned etch step to a depth exceeding said first depth, thereby dividing the layer of impurities into two segments on either side of the second trench, forming a gate dielectric layer on the surface of the second trench, forming a gate electrode on said gate dielectric layer, and forming electrical contacts to said two segments.

9. Method of claim 8 in which the gate electrode is polysilicon deposited so as to fill said second trench.

**Patentansprüche**

1. MOS-Transistorvorrichtung, umfassend
ein Halbleitersubstrat,
einen Graben (11), der in das Halbleitersubstrat eingeformt ist und ein erstes Paar einander gegenüberstehender Seitenwände, ein zweites Paar einander gegegenüberstehender Seitenwände und einen Boden aufweist,
gekennzeichnet durch
eine MOS-Transistor-Sourcezone (13), die sich längs einer Seitenwand des ersten Paares erstreckt,
eine MOS-Transistor-Drainzone (14), die sich längs der anderen Seitenwand des ersten Paares erstreckt,
eine dielektrische Gateschicht (15), die das zweite Paar der Seitenwände wenigstens teilweise bedeckt, und
eine MOS-Transistor-Gateelektrode (12), die sich längs der Seitenwände des zweiten Paares erstreckt, wobei die eine Kante der Gateelektrode über der Kante der Sourcezone liegt und die andere Kante der Gateelektrode über der Kante der Drainzone liegt.

2. Vorrichtung nach Anspruch 1, bei der der Halbleiter Silicium ist.

3. Vorrichtung nach Anspruch 1, bei der die Gateelektrode Polysilicium ist.

4. Vorrichtung nach Anspruch 1, des weiteren umfassend eine zusätzliche Transistorvorrichtung, wie diese in Anspruch 1 definiert ist, benachbart zur ersten Transistorvorrichtung, wobei die Gateelektrode des ersten Transistors und die des zusätzlichen Transistors miteinander vereinigt sind.

5. Verfahren zum Herstellen einer MOS-Transistorvorrichtung, wie diese in einem der vorstehenden Ansprüche beansprucht ist, umfassend die Schritte
Ausbilden eines Grabens in einer Fläche eines Halbleitersubstrates, wobei der Graben ein Paar gegenüberstehender Seitenwände, ein Paar gegenüberstehender Stirnwände sowie einen Boden aufweist,
gekennzeichnet durch
Ausbilden einer Gatestruktur (12, 15) in dem Graben (11), die sich kontinuierlich längs einer Seitenwand nach unten, längs des Grabenbodens und längs der anderen Seitenwand nach oben erstreckt und eine dielektrische Schicht sowie eine über dieser gelegene Eletrodenschicht aufweist,

Ausbilden einer ersten Fremdstoffzone in den von der Gateelektrode nicht bedeckten Oberflächenzonen des Grabens,

Ausbilden eines Sourcekontaktes zu der Fremdstoffzone auf der einen Seite der Gateelektrode und

Ausbilden eines Drainkontaktes zu der Fremdstoffzone auf der anderen Seite der Gateelektrode.

6. Verfahren nach Anspruch 5, bei dem sich die Fremdstoffzone zur sowie längs der Oberfläche des Substrates erstreckt und die Source- und Drainkontakte auf der Oberfläche erzeugt werden.

7. Verfahren nach Anspruch 5, bei dem die Gatestruktur erzeugt wird durch

Ausbilden einer dielektrischen Gateschicht auf wenigstens den Stirnwänden und dem Boden des Grabens,

Verfüllen des Grabens mit Polysilicium auf eine Höhe annähernd der Höhe der Oberfläche des Substrates,

Ausbilden einer Maske für die Gatestruktur auf der Oberfläche des Polysiliciums,

Durchätzen des unmaskierten Polysiliciums zum Boden des Grabens,

Offenbelassen eines Teils des ursprünglichen Grabens auf jeder Seite der Gatestruktur,

Einführen von Fremdstoffen in die offenen Teile zur Bildung der Source- und Drainzonen und

Verfüllen der offenen Teile mit dielektrischem Material.

8. Verfahren nach Anspruch 5, bei dem die Gatestruktur erzeugt wird durch

Einführen von Fremdstoffen in die Wände des Grabens bis zu einer ersten Tiefe, um eine Fremdstoffschicht längs der Stirnwände, Seitenwände und des Bodens zu erzeugen,

Füllen des Grabens mit dielektrischem Material auf eine Höhe angenähert der Höhe der Oberfläche des Substrates,

Maskieren des dielektrischen Materials mit einer Resistschicht, die einen sich zwischen den Stirnwänden des Grabens und im Abstand von jeder Seitenwand erstreckenden Streifen freilegt,

Ätzen des freigelegten dielektrischen Materials zur Ausbildung eines zweiten Grabens, der kleiner ist als der erste, und sich zwischen den Stirnwänden sowie im Abstand von den Seitenwänden erstreckt,

Ätzen der freiliegenden, durch den vorerwähnten Ätzschritt freigelegten Teile der Grabenwände auf eine die erste Tiefe übersteigende Tiefe, um dadurch die Fremdstoffschicht in zwei Segmente auf jeder Seite des zweiten Grabens zu unterteilen,

Erzeugen einer dielektrischen Gateschicht auf der Oberfläche des zweiten Grabens,

Erzegen einer Gateelektrode auf de dielektrischen Gateschicht und

Erzeugen elektrischer Kontakte zu den beiden Segmenten.

9. Verfahren nach Anspruch 8, bei dem die Gateelektrode Polysilicium ist, das zur Verfüllung des zweiten Grabens niedergeschlagen wird.

**Revendications**

1. Dispositif consistant en un transistor MOS, comprenant:

un substrat semiconducteur,

une tranchée (11) formée dans ce substrat semiconducteur, cette tranchée comprenant une première paire de parois latérales disposées en regard, une seconde paire de parois latérales disposées en regard, et un fond,

caracterise par

une région de source du transistor MOS (13) qui s'étend le long d'une paroi de la première paire de parois latérales,

une région de drain du transistor MOS (14) qui s'étend le long de l'autre paroi de la première paire de parois latérales,

une couche diélectrique de grille (15) qui recouvre au moins partiellement la seconde paire de parois latérales,

et une électrode de grille du transistor MOS (12) qui s'étend le long de la seconde paire de parois latérales, un bord de l'électrode de grille recouvrant le bord de la région de source, et l'autre bord de l'électrode de grille recouvrant le bord de la région de drain.

2. Dispositif selon la revendication 1, dans lequel le semiconducteur est du silicium.

3. Dispositif selon la revendication 1, dans lequel l'électrode de grille est en silicium polycristallin.

4. Dispositif selon la revendication 1, comprenant en outre un dispositif supplémentaire consistant en un transistor, tel que celui défini dans la revendication 1, qui est adjacent au premier, avec l'électrode de grille du premier transistor et l'électrode de grille du transistor supplémentaire combinées ensemble.

5. Procédé de fabrication d'un dispositif consistant en un transistor MOS selon l'une quelconque des revendications précédentes, comprenant les étapes suivantes:

on forme une tranchée dans une surface d'un substrat semiconducteur, cette tranchée comportant une paire de parois latérales opposées, une paire de parois d'extrémités opposées et un fond,

caracterise en ce que

on forme une structure de grille (12, 15) dans la tranchée (11), cette structure s'étendant de façon continue en descendant le long d'une paroi latérale, en passant sur le fond de la tranchée et en remontant le long de l'autre paroi latérale, et cette structure de grille comprenant une couche diélectrique et une couche d'électrode qui recouvre la couche diélectrique,

on forme une première région d'impureté dans les régions de surface de la tranchée qui ne sont pas recouvertes par l'électrode de grille, et

on forme un contact de source avec la région d'impureté, d'un côté de l'électrode de grille, et

on forme un contact de drain avec la région d'impureté de l'autre côté de l'électrode de grille.

6. Le procédé de la revendication 5, dans lequel la région d'impureté s'étend jusqu'à la surface précitée du substrat, et le long de cette surface, et les contacts de source et de drain sont formés sur cette surface.

7. Le procédé de la revendication 5, dans lequel on forme la structure de grille en formant une couche de diélectrique de grille au moins sur les parois d'extrémités et sur le fond de la tranchée, on remplit la tranchée avec du silicium polycristallin jusqu'à un niveau qui est proche du niveau de la surface du substrat, on forme un masque pour la structure de grille sur la surface du silicium polycristallin, on attaque le silicium polycristallin non masqué, jusqu'au fond de la tranchée, ce qui laisse une partie de la tranchée d'origine ouverte de part et d'autre de la structure de grille, on introduit des impuretés dans les parties ouvertes pour former les régions de source et de drain, et on remplit les parties ouvertes avec un matériau diélectrique.

8. Le procédé de la revendication 5, dans lequel on forme la structure de grille en introduisant des impuretés dans les parois de la tranchée, jusqu'à une première profondeur, pour former une couche d'impuretés le long des parois d'extrémités, des parois latérales et du fond, on remplit la tranchée avec un matériau diélectrique jusqu'à un niveau approximativement égal au niveau de la surface du substrat, on masque le matériau diélectrique avec une couche de résine photosensible qui laisse à nu une bande s'étendant entre les parois d'extrémités de la tranchée, et qui est espacée de chaque paroi latérale, on attaque le matériau diélectrique à nu, pour former une seconde tranchée, plus petite que la première, qui s'étend entre les parois d'extrémités et qui est espacée des parois latérales, on attaque les parties à nu des parois de la tranchée qui ont été mises à nu par l'étape d'attaque précitée, jusqu'à une profondeur supérieure à la première profondeur, ce qui divise la couche d'impuretés en deux segments situés de part et d'autre de la seconde tranchée, on forme une couche de diélectrique de grille sur la surface de la surface de la seconde tranchée, on forme une électrode de grille sur la couche de diélectrique de grille, et on forme des contacts électriques sur les deux segments précités.

9. Procédé selon la revendication 8, dans lequel l'électrode de grille consiste en silicium polycristallin déposé de façon à remplir la seconde tranchée.

FIG.1

FIG.2A

FIG.2B

FIG.3

FIG.4

FIG.5A

*FIG. 5B*

SiO₂
51 54 Si₂N₄
53 52 PAD SiO₂

FOX

56    56    56

50

CUT TRENCH

*FIG. 5C*

51 52 53

FOX

50

STRIP OXIDE MASK

*FIG. 5D*

51 53          52a      52   53

FOX

GROW SACRIFICIAL OXIDE
IN TRENCH

## FIG. 5E

STRIP NITRIDE

## FIG. 5F

## FIG. 5G

4

## FIG. 5H

## FIG. 5J

## FIG. 5K

*FIG. 5L*

75  76  75  77

73  74  70

*FIG. 6*

62  61

65  66

63  64

*FIG. 7A*

71  72  73  73  73  71

70

## FIG. 7B

## FIG. 7C

## FIG. 7D

## FIG. 7E

## FIG.7F

79  75  80

77  78

## FIG.8A

81
84  83
82  85
85
85
91
91
91
91

86
86
86

80

## FIG.8B

86
86
86

91
92
92
92

*FIG.8C*

93

92

*FIG.8D*

94

92

*FIG.8E*

92a    92b

95

FIG.8F